## Europäisches Patentamt

(19) **European Patent Office**

**Office européen des brevets**

(11) Numéro de publication: **0 133 137**
**B1**

(12) # FASCICULE DE BREVET EUROPEEN

(45) Date de publication du fascicule du brevet:
**17.11.88**

(51) Int. Cl.⁴: **H 03 M 13/00**

(21) Numéro de dépôt: **84401597.4**

(22) Date de dépôt: **30.07.84**

(54) **Système de correction d'erreurs de signaux numériques codés en code de Reed-Solomon.**

(30) Priorité: **29.07.83 FR 8312581**

(43) Date de publication de la demande:
**13.02.85 Bulletin 85/7**

(45) Mention de la délivrance du brevet:
**17.11.88 Bulletin 88/46**

(84) Etats contractants désignés:
**AT BE CH DE FR GB IT LI LU NL SE**

(56) Documents cités:
**EP - A - 0 061 345**
**GB - A - 2 093 238**

**SYSTEMS-COMPUTERS-CONTROLS, vol. 11, no. 6, novembre-décembre 1980, pages 58-67, Scripta Publishing Co., Silver Spring, Maryland, US; A. YAMAGISHI et al.: "A construction method for decoders of BCH codes using ROM's"**
**IEEE TRANSACTIONS ON COMPUTERS, vol. C-31, no. 2, février 1982, pages 170-175, IEEE, New York, US; K.Y. LIU: "Architecture for VLSI design of reed-solomon encoders"**
**IBM TECHNICAL DISCLOSURE BULLETIN, vol. 23, no. 10, mars 1981, pages 4597-4599, New York, US; C.L. CHEN: "Parallel implementation of double-error correction and triple-error detection"**

(73) Titulaire: **Etablissement Public de Diffusion dit "Télédiffusion de France", 21-27 rue Barbès, F-92120 Montrouge (FR)**

(72) Inventeur: **Catrevaux, Alain R., 24, Avenue des Tilleuls, F-94320 Thiais (FR)**
Inventeur: **Bertin, Pierre, Décédé (FR)**

(74) Mandataire: **Martinet & Lapoux, 62, rue des Mathurins, F-75008 Paris (FR)**

(56) Documents cités: (suite)
**IBM TECHNICAL DISCLOSURE BULLETIN, vol. 18, no. 10, mars 1976, pages 3320-3321, New York, US; H.P. DUVOCHEL et al.: "Block check character determination in table look-up procedure"**
**W. Peterson, "Prüfbare und korrigierbare Codes" 1967, pp. 216-239**

ACTORUM AG

## Description

La présente invention concerne un codeur et un décodeur de données numériques dans un code correcteur d'erreurs et, plus particulièrement, un codeur et un décodeur convertissant le code binaire en code de Reed-Solomon et vice-versa.

Le but général de l'invention est de restreindre le volume de calculs nécessaires au codage ou au décodage dans le code de Reed-Solomon et plus particulièrement de limiter au quatrième degré, le degré des équations algébriques à résoudre.

Le code de Reed-Solomon est décrit par exemple dans l'ouvrage «The Theory of Error-Correcting Codes» par F.J. MacWilliams et N.J.A. Sloane, North Holland Publishing Company, 1981, Chapitre 10.

On rappel qu'un code de Reed-Solomon dans un champ fini de Galois CG(q) est un code de Bose, Chaudhuri, Hocquenhem (BCH) de longueur $n = q - 1$.

Les codes BCH sont des codes dont le polynôme générateur est par définition le suivant:

$$G(x) = (x - a^{m_0}) (x - a^{m_0+1}) \ldots (x - a^{m_0+\delta-2})$$

où $\delta$ est la distance désignée. Avec $\delta - 2 = 2t + 1$ si t désigne le nombre d'erreurs à corriger.

Les racines de G(x) sont donc les puissances successives d'un élément primitif appartenant à CG (2). Cela veut dire que dans un mot de code:

$$V(x) = y_{n-1}x^{n-1} + \ldots y_{n-1}x^{n-1} + \ldots y_0$$

$Y_{n-i}$ a deux valeurs possibles 0 ou 1; et $x^{n-i}$ détermine la position de $y_{n-i}$.

Dans un code de Reed-Solomon, la caractéristique du champ n'est plus 2 mais un entier premier quelconque b donnant lieu à un champ CG $(b^p)$. Chaque $y_{n-i}$ n'a plus deux formes possibles mais

$q = b^{'p}$ formes. Le coefficient $y_{n-i}$ est un symbole du code.

On définit ainsi des polynômes dont les coefficients sont non plus seulement des entiers 0 ou 1 (base 2) mais des éléments de CG $(b^p)$ qui seront exprimés par p éléments binaires.

Par exemple, si $m_0 = 0$, $q = 2^3$ et si le polynôme caractéristique qui génère les éléments du corps est égal à $x^3 + x^2 + 1$, chaque coefficient va s'exprimer sous la forme d'un mot de 3 bits.

| $a^2$ | a | 1 | |
|---|---|---|---|
| 0 | 0 | 1 | 1 |
| 0 | 1 | 0 | a |
| 1 | 0 | 0 | $a^2$ |
| 1 | 0 | 1 | $a^3 = 1 + a^2$ |
| 1 | 1 | 1 | $a^4 = a + a^3 = 1 + a + a^2$ |
| 0 | 1 | 1 | $a^5 = a + a^2 + 1 + a^2 = 1 + a$ |
| 1 | 1 | 0 | $a^6 = a + a^2$ |
| 0 | 0 | 1 | $a^7 = a^2 + a^3 = a^2 + a^2 + 1 = 1$ |

On définit alors, comme pour le cas binaire, les racines du polynôme et pour $m_0 = 0$, le polynôme générateur de code est:

$$G(x) = (x - 1) (x - a) \ldots (x - a^{\delta-2})$$

Le polynôme générateur doit avoir un nombre de racines égal à 2 fois le nombre t d'erreurs à corriger. En effet, la racine a la puissance la plus élevée.

$$a^{\delta-2} = a^{2t+1-2} = a^{2t-1}$$

Les racines du polynôme générateur sont donc:

$$1, a, a^2, \ldots a^{2t-1}$$

Comme on a pris $q = 8$, les mots du code ont une longueur de $N = 7$ symboles. Un code C (7, 4) contient quatre symboles d'information et trois symboles de contrôle de chacun trois bits. Le mot de code s'écrit par exemple:

$$\underbrace{(001)x^6 + (101)x^5 + (000)x^4 + (000)x^3}_{I(x)} + \underbrace{(011)x^2 + 101x^1 + (010)x^0}_{R(x)}$$

ou I(x) désigne les symboles d'information et R(x) les symboles de contrôle constitués par le reste de la division I(x) par G(x).

Une erreur est caractérisée par sa valeur et sa position dans un mot de code donné. Dans le cas d'un code binaire, il suffit de déterminer la position de l'erreur, sa valeur étant obtenue en complémentant la valeur erronée à la position calculée. Donc corriger deux erreurs à l'aide d'un code binaire revient à résoudre un système de deux équations à deux inconnues. A ce sujet, on peut se référer aux documents suivants:

W. Peterson, Prüfbare und Korrigierbare Codes, 1967, pages 216–239 et Systems-Computers-Controls, vol. 11, n° 6, 1980, pages 58–67. Par contre, dans le cas d'un code de Reed-Solomon, un symbole du code représente un paquet de p éléments binaires. Dans ce cas, deux erreurs sont caractérisées par quatre paramètres, respectivement leurs deux valeurs et positions.

La présente invention concerne un codeur-décodeur convertissant un message informationnel exprimé en code binaire en un message exprimé en code de Reed-Solomon et inversement, comprenant:

des moyens de sélection d'un polynôme générateur de code G (x) ayant comme racines les puissances successives d'un élément primitif appartenant au champ de Galois CG $(2^3)$;

des moyens de division dudit message informationnel par ledit polynôme générateur de code G (x), lesdits moyens de division permettant d'obtenir un mot de code

$$V(x) = \sum_{i=0}^{i=n-1} y_i x^i \text{ comprenant}$$

(n − 8) symboles d'information et 8 symboles de code, formule dans laquelle y donne la valeur du symbole, x la position du symbole et n le degré du mot de code;

des moyens de réception desdits mots de code éventuellement entachés d'au plus quatre erreurs au cours de leur transmission;

des moyens de calculer des syndromes d'erreurs

$$V(a^j) = \sum_{i=0}^{i=n-1} y_i (a^j)^i = S_j$$

où j peut prendre les valeurs de 0 à 7 inclus, ces syndromes d'erreurs étant les valeurs prises par le mot de code reçu quand on y remplace la variable par les éléments $(a^j)$ du champ de Galois CG $(2^3)$;

des moyens de calculer à partir desdits syndromes les coefficients $\delta_t$ où t est au plus égal à 4 d'un polynôme localisateur d'erreurs, lesdits coefficients dépendant desdits syndromes par un premier système d'équations linéaires;

$$S_4 + \delta_1 S_3 + \delta_2 S_2 + \delta_3 S_1 + \delta_4 S_0 = 0$$
$$S_7 + \delta_1 S_6 + \delta_2 S_5 + \delta_3 S_4 + \delta_4 S_3 = 0$$

des moyens de calculer les racines dudit polynôme localisateur d'erreurs, lesdites racines étant les positions des erreurs dans le mot de code;

ledit codeur-décodeur étant caractérisé en ce qu'il comprend en outre des moyens de former un second système d'équations linéaires ((18))

$$S_0 = Y_1 + A_2 + Y_3 + Y_4$$
$$S_3 = Y_1 X_1^3 + Y_2 X_2^3 + Y_3 X_3^3 + Y_4 X_4^3$$

reliant les valeurs y des erreurs aux syndromes S et aux positions x des erreurs délivrés respectivement par les moyens de calculer les syndromes d'erreurs et par les moyens de calculer les racines du polynôme localisateur d'erreurs, des moyens de résoudre ledit second système d'équations linéaires, les valeurs trouvées pour y étant les valeurs des erreurs; et en ce que les moyens de calculer les racines du polynôme localisateur d'erreurs comprennent;

des unités de calcul permettant de résoudre respectivement, en en calculant les racines, les équations du quatrième degré, du troisième degré et du second degré; et

des moyens d'appliquer ledit polynôme localisateur d'erreurs auxdites unités de calcul du quatrième, troisième, second degrés selon que ledit polynôme localisateur est lui-même du quatrième, du troisième ou du second degré.

L'invention tant en ce qui concerne le codeur que le décodeur du code Reed-Solomon, va être maintenant décrite en détail en relation avec les dessins annexés, dans lesquels:

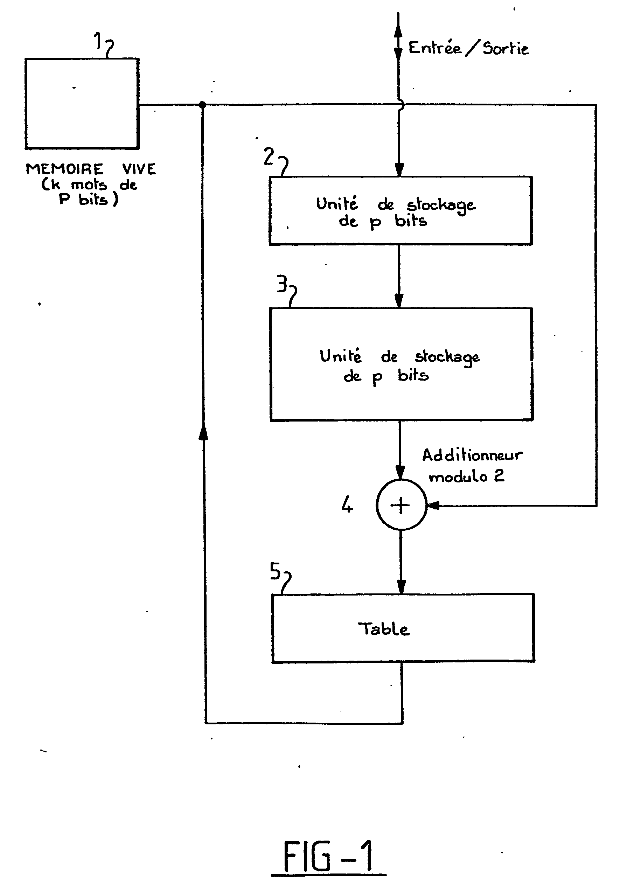

– la Fig. 1 représente sous la forme d'un diagramme de blocs le codeur pour code de Reed-Solomon conforme à l'invention;

– la Fig. 2 représente le décodeur pour code de Reed-Solomon conforme à l'invention; et

– la Fig. 3 représente l'algorithme de décodage.

## 1. Codage

Ainsi qu'on l'a dit dans l'entrée en matière, les symboles du code sont des éléments du champ fini de $2^p$ éléments. Chaque symbole du code comporte p éléments binaires. Les symboles de contrôle sont obtenus en divisant le message informationnel I(x) par le polynôme générateur G(x).

Le code comporte m symboles d'information et k symboles de contrôle. On désigne le code par C(m + k, m). Une méthode de codage bien connue consiste à prémultiplier I(x) par $x^k$, k étant le degré le plus élevé du polynôme générateur et à diviser le produit ainsi obtenu par G(x), soit:

$$\frac{x^k I(x)}{G(x)}$$

où G(x) a la forme polynomiale précédemment indiquée avec k = m + $\delta$ – 1.

Le code décrit est un code C(255, 247) avec $2^p = 2^8$,

d'où

$$G(x) = x^8 + Ax^7 + Bx^6 + Cx^5 + Dx^4 = Ex^3 + Fx^2 + Gx + H \qquad (20)$$

Les coefficients A, B, C, D, E, F, G et H sont des mots de huit bits.

Lorsque le premier symbole apparaît à l'entrée du système, les restes partiels précédents sont nuls. Soit $S_1$, ce premier symbole. Le circuit 2 stocke temporairement $S_1$ le temps que le circuit 3 fournisse le résultat de la multiplication $S_1$ par chacun des termes du polynôme générateur. Ces restes partiels sont stockés dans le circuit 1 dans un ordre qui est une caractéristique du système.

Quand le deuxième symbole $S_2$ se présente à l'entrée du système, on additionne modulo 2, $S_2$ avec le reste partiel précédent de degré le plus élevé. Le résultat de cette opération est stocké dans 2. Ensuite, le circuit 3 effectue les multiplications avec les restes partiels précédents et le processus continue, jusqu'à ce que le 247ième symbole d'information soit rentré dans le système.

Le circuit 1 est une mémoire vive de k mots de p bits.

Les circuits 2 et 3 sont des unités de stockage de p bits.

Le circuit 4 est un additionneur modulo 2 de p bits.

Quant au circuit 5, il est constitué d'une table inaltérable qui, adressée par $(S_i + R_{pi})$ fournit respectivement les produits de $(S_i + R_{pi})$ par chacun des coefficients de G(x).

Avec $S_i$ désignant le symbole informationnel d'ordre i et $R_{pi}$, le reste partiel d'ordre i est de même degré que $S_i$.

Lorsque tous les symboles d'information constituant I(x) sont entrés dans le système, le circuit 1 contient les 8 symboles de contrôle rangés dans un certain ordre. Symboles qu'il suffit d'appeler en ligne à la suite de $x^k$ I(x) pour finir de constituer le mot de code.

**2. Décodage**

Le décodeur conforme à l'invention utilise un système unique pour calculer:

– les syndromes d'erreurs;

– les coefficients du polynôme localisateur d'erreur;

– les racines du polynôme localisateur d'erreurs;

– les diagrammes d'erreurs correspondant aux positions d'erreurs calculées;

– les corrections.

**Calcul des syndromes**

$V(x)$ étant un mot de code, s'il y a des erreurs, il s'écrit $V'(x) = V(x) + E(x)$.

$E(x)$ étant la configuration d'erreurs apparue au cours de la transmission.

Afin de déceler les erreurs à la réception, il faut soit vérifier que les mots reçus sont divisibles ou non par le polynôme générateur, soit vérifier que chaque mot de code admet pour racines les racines du polynôme générateur. Cette deuxième solution est celle utilisée pour le décodage de la présente invention.

Un mot de code $V(x)$ s'écrit sous la forme d'un polynôme de la manière suivante, ainsi qu'on l'a vu précédemment

$$V(x) = y_{n-1}x^{n-1} + y_{n-2}x^{n-2} + \ldots y_{n-i}x^{n-i} + \ldots y_0x^0 \quad (1)$$

Si $V(x)$ admet $a^j$ pour racine, cela s'écrit:

$$V(a^j) = y_{n-i}(a^j)^{n-1} + y_{n-2}(a^j)^{n-2} + \ldots$$
$$y_{n-i}(a^j)^{n-i} + \ldots + y_0(a^j)^0$$

$$V(a^j) = \sum_{i=n-1}^{i=o} y_i(a^j)^i = S_j \quad (2)$$

S'il y a une erreur, on reçoit non plus le mot de code $V(a^j)$ mais le mot de code

$$V'(a^j) = V(a^j) + E(a^j) = E(a^j)$$

puisque $V(a^j) = 0$.

$S_j$ est le syndrome d'erreur d'ordre j, il faut calculer les syndromes $S_j$ avant de pouvoir déterminer la position et la valeur des erreurs.

Si on reçoit un mot erroné, il y a donc une certaine configuration d'erreurs $E(x)$ dont chacune peut être repérée par un couple $x_i$, $y_i$ (position et valeur).

**Calcul des coefficients du polynôme localisateur d'erreurs à partir des syndromes**

Si on veut corriger t erreurs (t positions, t valeurs), le polynôme localisateur d'erreurs s'écrit:

$$X_i^t + \sigma_1 X_i^{t-1} + \sigma_2 X_i^{t-2} + \ldots \sigma_j X_i^{t-j} + \ldots \sigma_t = 0 \quad (3)$$

C'est une équation de degré t.

Les coefficients $\sigma_1$, $\sigma_2 \ldots \sigma_t$ sont obtenus en résolvant le système suivant:

$$S_t + \sigma_1 S_{t-1} + \sigma_2 S_{t-2} + \ldots \sigma_j S_{t-j} + \ldots + \sigma_t S_o = 0$$
$$S_{t-1} + \sigma_1 S_t + \sigma_2 S_{t-1} + \ldots \ldots \ldots + \sigma_t S_1 = 0$$
$$S_{2t-1} + \sigma_1 S_{2t-2} + \ldots \ldots \ldots \ldots \ldots + \sigma_t S_{t-1} = 0$$

Soit $\Delta$ le déterminant principal du sytème, il est égal à:

$$\Delta = \begin{vmatrix} S_{t-1} & S_{t-2} & \ldots \ldots \ldots & S_{t-i} & \ldots \ldots \ldots & S_o \\ S_t & S_{t-1} & \ldots \ldots \ldots & S_{t-i+1} & \ldots \ldots \ldots & S_1 \\ \vdots & & & & & \vdots \\ S_{2t-2} & S_{2t-3} & \ldots \ldots \ldots & S_{2t-i-1} & \ldots \ldots \ldots & S_{t-1} \end{vmatrix}$$

En appliquant les règles sur la résolution des systèmes d'équation linéaires, il vient: $\sigma_i = \Delta_i/\Delta$ où

$$\Delta_i = \begin{vmatrix} S_{t-1} & S_{t-2} & \ldots \ldots \ldots & S_t & \ldots \ldots \ldots & S_o \\ S_t & S_{t-1} & \ldots \ldots \ldots & S_{t+1} & \ldots \ldots \ldots & S_i \\ \vdots & \vdots & & \vdots & & \vdots \\ S_{2t-2} & S_{2t-3} & & S_{2t-1} & & S_{t-1} \end{vmatrix}$$

Les coefficients de polynôme localisateur d'erreurs ont donc pour valeurs respectives les valeurs suivantes:

$$\sigma_t = \Delta_t/\Delta \ldots \ldots \sigma_i = \Delta_i/\Delta \ldots \ldots \sigma_1 = \Delta_1/\Delta \quad (4)$$

**Calcul des racines du polynôme localisateur d'erreurs**

L'équation (3) n'étant résoluble que si elle est au plus du quatrième degré, le système peut corriger jusqu'à quatre erreurs. Les positions des quatre erreurs sont donc solutions de:

$$X^4 + \sigma_1 X^3 + \sigma_2 X^2 + \sigma_3 X + \sigma_4 = 0 \quad (3')$$

si l'équation (3') a un terme en $X^4$, elle est appliquée à un calculateur des racines d'une équation bicarrée; si l'équation (3') n'a pas de terme $X^4$ mais un terme en $X^3$ elle est appliquée à un calculateur de racines d'une équation du 3ème degré; si l'équation (3') n'a ni terme en $X^4$, ni terme en $X^3$ mais a un terme en $X^2$, elle est appliquée à un calculateur des racines d'une équation du second degré.

L'équation (3') quand elle est du quatrième degré peut se mettre sous la forme bicarrée:

$$(X^2 + \lambda X + \mu)(X^2 + \lambda' X + \mu') = 0 \quad (5)$$

Avec
$$\left. \begin{array}{l} \sigma_1 = \lambda + \lambda' \\ \sigma_2 = \mu + \mu' + \lambda\lambda' \\ \sigma_3 = \lambda\mu' + \lambda'\mu \\ \sigma_4 = \mu\mu' \end{array} \right\} \quad (6)$$

Pour localiser les erreurs, il suffit de déterminer les valeurs de $\lambda$, $\lambda'$, $\mu$ et $\mu'$, puis les racines de chacune des équations du second degré. Pour résoudre le système (6), deux cas se présentent suivant que $\sigma_1$ est nul ou non nul, en effet:

Le système (6) devient pour $\sigma_1 = 0$

$$\left. \begin{array}{l} \lambda + \lambda' = 0 \\ \sigma_2 = \mu + \mu' + \lambda^2 \\ \sigma_3 = \lambda(\mu + \mu') \\ \sigma_4 = \mu\mu' \end{array} \right\} \quad (7)$$

d'où:

$$\left.\begin{aligned}\sigma_2&=\frac{\sigma_3}{\lambda}+\lambda^2\\ \lambda^3+\sigma_2\lambda+\sigma_3&=0\end{aligned}\right\}\qquad(8)$$

Cette équation est du troisième degré en $\lambda$ et fournit une racine $\lambda_1$. Les quantités $\mu$ et $\mu'$ sont solution d'une équation du second degré, sachant que:

$\mu+\mu'=\sigma_3/\lambda_1$

$\mu\mu'=\sigma_4$

$\mu$ et $\mu'$ sont racines de

$$\mu^2+(\sigma_3/\lambda_1)\,\mu+\sigma_4=0\qquad(9)$$

Pour $\sigma_1 \neq 0$, on a en posant

$\sigma_1 = \lambda+\lambda'$

$\rho = \lambda\lambda'$ (10)

On aboutit à une équation du troisième degré en $\rho$, soit:

$$\rho^3+(\sigma_1\,\sigma_3+\sigma_2^2)\,\rho+\sigma_1^2\,\sigma_4+\sigma_3^2+\sigma_1\,\sigma_2\,\sigma_3 = 0\qquad(11)$$

On en tire une racine $\rho_1$ par exemple: D'où $\lambda$ et $\lambda'$ sont solution d'une équation du second degré, soit:

$$\lambda^2+\sigma_1\,\lambda+\rho_1 = 0\qquad(12)$$

Le système (6) permet alors de déduire les valeurs de $\mu$ et de $\mu'$.

Résolution d'une équation du troisième degré de type (8) ou (11)

Ces deux équations sont de la forme:

$$y^3+vy+\tau = 0\qquad(13)$$

Cette équation peut se mettre sous la forme canonique (coefficient de y égal à l'unité) en posant:

$z = y/v^{1/2}$

et

$Q = \tau/v^{3/2}$

ce qui donne:

$$z^3+z+Q = 0\qquad(14)$$

Si p est pair, deux cas se présentent pour trouver une racine cubique dans le champ CG($2^p$).

1) Si $v = 0$

L'équation (13) devient:

$y^3+\tau = 0$ est donné par une table

$y_3 = \tau^{1/3}$

Ensuite:

$y_1+y_2+y_3 = 0$

$y_1\,y_2\,y_3 = \tau$

$y_1$ et $y_2$ sont alors solution de:

$$y^2+y_3\,y+\tau/y_3 = 0\qquad(15)$$

Equation qui se met sous la forme canonique suivante:

$$Y^2+Y+R = 0\qquad(16)$$

avec $Y = y/y_3$ $\quad R = \tau/y_3^3 = 1$

2) Si $v \neq 0$, il faut alors résoudre l'équation (14). $z_3$ est obtenu par une table adressée par Q. Les racines $z_1$ et $z_2$ sont obtenues par une méthode identique à celle qu'on vient de voir pour $\upsilon = 0$ et $R \neq 1$.

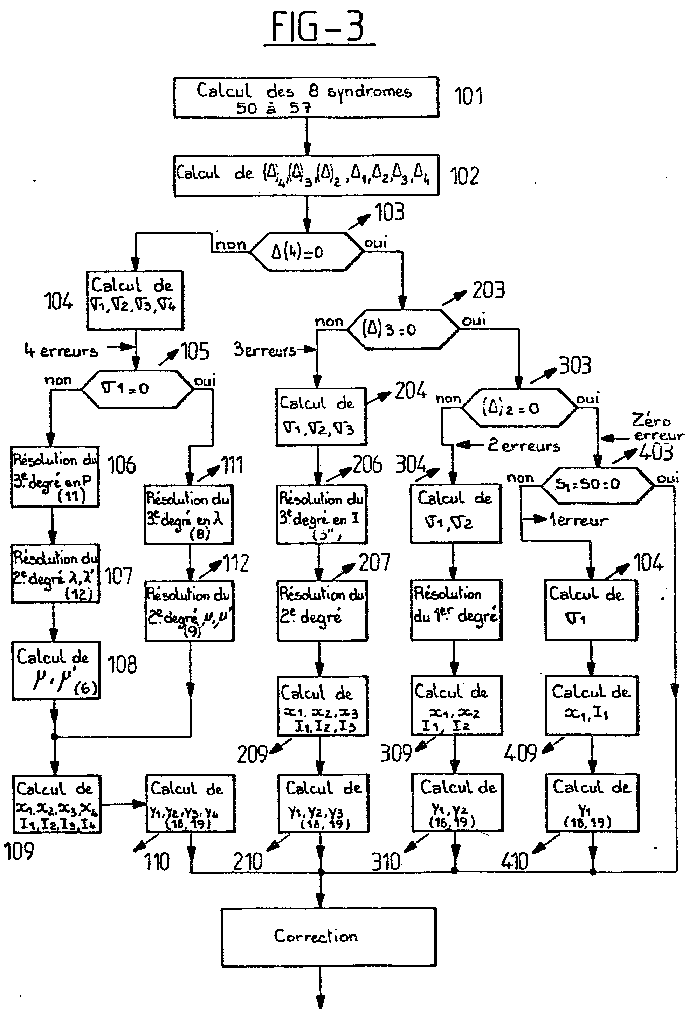

La Fig. 3 représente l'algorithme de décodage.

Le nombre d'erreurs que l'on s'impose de corriger est de quatre, trois, deux ou un.

La phase 101 représente le calcul des syndromes qui dans l'exemple décrit seront au nombre de 8, $S_7$ à $S_0$. La phase 102 représente le calcul de $(\Delta)_4$, $(\Delta)_3$, $(\Delta)_2$, déterminant principal dans le cas de 4, 3 ou 2 erreurs, ainsi que celui de $\Delta_i$, i variant de 2 à 4, soit $\Delta = \Delta_1, \Delta_2, \Delta_3, \Delta_4$.

Si $(\Delta_4)$ est différent de zéro (phase 103), on en déduit qu'il y a 4 erreurs, et on va vers la phase 104 où l'on calcule $\sigma_1$, $\sigma_2$, $\sigma_3$, $\sigma_4$, définis par les équations (4).

Si $\sigma_1 \neq 0$ (phase 105), on passe à la phase 106 de calcul des racines de l'équation en $\rho$ (équation (11)), puis à la phase 107 de calcul des racines $\lambda$, $\lambda'$ de l'équation (12), enfin à la phase 108 de calcul des $\mu$ et $\mu'$ par les équations (6).

On passe ensuite à la résolution de l'équation (5) (phase 109), ce qui donne $X_1$, $X_2$, $X_3$, $X_4$ et on déduit l'adresse de l'erreur à l'aide de la formule (17). Enfin, phase 110, on calcule $\gamma_1$ à $\gamma_4$ par la formule (18).

Si (phase 105), on a $\sigma_1 = 0$, les phases (106–108) sont remplacées par les phases (111–112) qui correspondent respectivement à la résolution de l'équation en $\lambda^3$ (équation (8)) et à la résolution de l'équation en $\mu^2$ (équation (9)).

L'algorithme de la Fig. 3 représente également les phases de décodage dans le cas de la correction de trois erreurs et de deux erreurs. Dans ces deux cas, l'équation (3') devient:

trois erreurs:

$$X^3+\sigma_1X^2+\sigma_2\,X+\sigma_3 = 0\qquad(3'')$$

deux erreurs:

$$X^2+\sigma_1\,X+\sigma_2 = 0\qquad(3''')$$

L'équation (3'') peut être mise sous la forme canonique et une des racines est obtenue par la formule de Cardan (phase (206)). Les deux autres racines sont obtenues en résolvant une équation du second degré en X (phase 207).

On voit sur la Fig. 3 qu'il y a équivalence entre les phases ayant pour numéros de centaines 1, 2, 3, 4 et les mêmes numéros d'unités et de dizaines.

Dans tous les cas de figures à la valeur des coefficients près, on est ramené à la résolution d'une équation du troisième degré ou du deuxième degré mise sous forme canonique.

La position effective des erreurs est déterminée de la façon suivante:

Sachant que $X_i$ est de forme $X_i = a^{j_i}$ ($a^{j_i}$ étant un élément de CG ($2^p$)), $j_i$ caractérise la position de l'erreur, d'où:

$$j_i = \mathrm{Log}_a\,(X_i)\qquad(17)$$

La détermination des $X_i$ permet alors de calculer les diagrammes d'erreurs $y_i$ correspondants.

$$\left.\begin{array}{l} S_0 = Y_1 + Y_2 + Y_3 + Y_4 \\ S_1 = Y_1 X_1 + Y_2 X_2 + Y_3 X_3 + Y_4 X_4 \\ S_2 = Y_1 X_1^2 + Y_2 X_2^2 + Y_3 X_3^2 + Y_4 X_4^2 \\ S_3 = Y_1 X_1^3 + Y_2 X_2^3 + Y_3 X_3^3 + Y_4 X_4^3 \end{array}\right\} \quad (18)$$

On voit sur les équations (18) que $S_0$ à $S_3$ sont des contributions des symboles dans lesquels se trouve une erreur à la formation des syndromes.

$$D = \begin{array}{cccc} 1 & 1 & 1 & 1 \\ X_1 & X_2 & X_3 & X_4 \\ X_1^2 & X_2^2 & X_3^2 & X_4^2 \\ X_1^3 & X_2^3 & X_3^3 & X_4^3 \end{array}$$

$$D_{y1} = \begin{array}{cccc} S_0 & 1 & 1 & 1 \\ S_1 & X_2 & X_3 & X_4 \\ S_2 & X_2^2 & X_3^2 & X_4^2 \\ S_3 & X_2^3 & X_3^3 & X_4^3 \end{array}$$

$$D_{y2} = \begin{array}{cccc} 1 & S_0 & 1 & 1 \\ X_1 & S_1 & X_3 & X_4 \\ X_1^2 & S_2 & X_3^2 & X_4^2 \\ X_1^3 & S_3 & X_3^3 & X_4^3 \end{array}$$

$$D_{y3} = \begin{array}{cccc} 1 & 1 & S_0 & 1 \\ X_1 & X_2 & S_1 & X_4 \\ X_1^2 & X_2^2 & S_2 & X_4^2 \\ X_1^3 & X_2^3 & S_3 & X_4^3 \end{array}$$

$$D_{y4} = \begin{array}{cccc} 1 & 1 & 1 & S_0 \\ X_1 & X_2 & X_3 & S_1 \\ X_1^2 & X_2^2 & X_3^2 & S_2 \\ X_1^3 & X_2^3 & X_3^3 & S_3 \end{array}$$

D'où on tire

$$Y_1 = \frac{D_{y1}}{D}; \quad Y_2 = \frac{D_{y2}}{D}; \quad Y_3 = \frac{D_{y3}}{D}; \quad Y_4 = \frac{D_{y4}}{D} \quad (19)$$

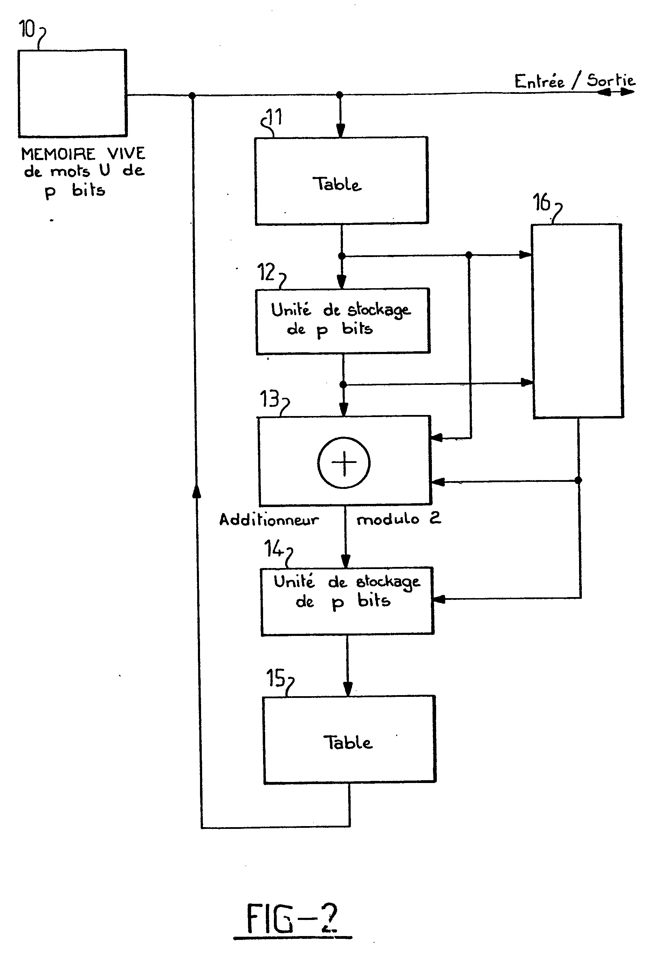

En se référant à la Fig. 2, au fur et à mesure de l'arrivée des symboles, le décodeur calcule $S_j$ conformément à l'équation (2) pour une valeur de $j$ donnée. Cette opération est réalisée autant de fois que $G(x)$ a de racines.

Le circuit 11 calcule pour un symbole de l'ordre $\ell$
$y_\ell (a^j)^\ell$ pour une racine $x_j = a^j$.

Ce résultat est alors stocké temporairement dans le circuit 12.

Le décodeur appelle la somme des $(n-\ell)$ termes précédents, stockée dans le circuit 10, le circuit 11 étant transparent. Le circuit 13 effectue la somme:

$$\sum_{i=n-1}^{\ell-1} y_1 (a^j)^i + y_\ell (a^j)^\ell$$

Le calcul de cette opération transite à travers l'unité de stockage 14 et le circuit 15 qui est transparent pour être stocké dans le circuit 10 jusqu'à l'arrivée du symbole suivant et l'opération décrite se renouvelle jusqu'à l'arrivée du dernier symbole. Les différents syndromes sont stockés dans le circuit 10.

Le décodeur est formé de trois unités de stockage:
- le circuit 10 qui est une mémoire vive de u mots de p bits, u étant une caractéristique du système,
- les circuits 12 et 14 qui sont des unités de stockage de p bits.

Un circuit 13 qui, lors du calcul des syndromes, fonctionne en additionneur modulo 2.

Un circuit 11 est une table dont une zone réservée multiplie le symbole présent à son entrée par les racines du polynôme générateur dans un ordre que le système définit à l'avance.

Un circuit 15 qui est une table dont on utilise une zone transparente lors de cette opération.

Les opérations nécessaires pour calculer les différents déterminants sont la multiplication et l'addition modulo 2.

La multiplication de deux éléments du champ d'extension CG $(2^p)$ est remplacée par l'addition modulo $(2^p-1)$ des logarithmes à base a de ces deux nombres, a étant un élément primitif du champ CG $(2^p)$.

Cas de multiplication

La valeur d'un syndrome stocké dans le circuit 10 transite dans le circuit 11 qui en donne logarithme. Ce résultat est stocké dans le circuit 12. En utilisant le même processus, on calcule par exemple le logarithme d'un autre syndrome. A ce moment, les sorties des circuits 11 et 12 attaquent le circuit 13 fonctionnant dans ce cas bien précis en additionneur modulo $(2^p-1)$. Le résultat de l'addition des deux logarithmes est stocké dans le circuit 14. A cet instant, le circuit 15 fournit l'antilogarithme du résultat issu de 14, résultat qui prend place dans une zone réservée du circuit 10.

Cas de l'addition

Dans ce cas, les circuits 11 et 15 sont transparents et le circuit 13 fonctionne en additionneur modulo 2.

Les coefficients $\sigma_1, \sigma_2 \ldots \sigma_1 \ldots \sigma_t$ calculés par la méthode ci-dessus sont stockés dans des zones bien définies du circuit 10.

Exemple
Soit:

$$x^8 + x^4 + x^3 + x^2 + 1$$

le polynôme caractéristique qui peut se mettre sous la forme d'un polynôme générateur de code

$$G(x) = (x - 1)(x - a) \ldots (x - a^3)$$

Comme ainsi qu'on l'a vu, il faut que le polynôme générateur ait un nombre de racine double du nombre d'erreurs à corriger, et comme il y a ici huit racines, on peut corriger quatre erreurs. Il y a donc huit syndromes $S_0$ à $S_7$ et ces syndromes sont calculés en remplaçant $a^j$ par successivement 1, a, $a^2$, $a^3$, $a^4$, $a^5$, $a^6$, $a^7$ et en faisant $n - 1 = 255$.

On suppose que les syndromes aient les valeurs suivantes:

$$S_0 = a^3$$
$$S^1 = a^5$$
$$S_2 = a^7$$
$$S_3 = a^9$$
$$S_4 = a^{11}$$
$$S_5 = a^{13}$$
$$S_6 = a^{15}$$
$$S_7 = a^{17}$$

On suppose en outre qu'il y ait une erreur ayant pour position $a^2$ et pour valeur $a^3$ où $a^2$ et $a^3$ sont des éléments du champ de Galois, CG($2^8$).

Le déterminant principal $\Delta$ qui permet la résolution des inconnues $\sigma_1$ à $\sigma_4$ (déterminant qui est d'ordre 4 pour quatre erreurs) s'écrit:

$$\Delta(4) = \begin{vmatrix} S_3 & S_2 & S_1 & S_0 \\ S_4 & S_3 & S_2 & S_1 \\ S_5 & S_4 & S_3 & S_2 \\ S_6 & S_5 & S_4 & S_3 \end{vmatrix} = 0$$

Ce déterminant est nul. Il y a donc au plus trois erreurs. On forme alors le déterminant principal.

$$\Delta(3) = \begin{vmatrix} S_3 & S_2 & S_1 \\ S_4 & S_3 & S_2 \\ S_5 & S_4 & S_3 \end{vmatrix} = 0$$

Ce déterminant est nul. Il y a donc au plus deux erreurs. On forme alors le déterminant principal.

$$\Delta(2) = \begin{vmatrix} S_3 & S_2 \\ S_4 & S_3 \end{vmatrix} = 0$$

Ce déterminant est nul. Il y a donc une seule erreur. On forme alors

$$\Delta(1) = |S_3| = S_3$$

et le déterminant

$$\Delta_1 = |S_4| = S_4$$

On a alors (équation (4))

$$\sigma_1 = \Delta_1/\Delta(1) = S_4/S_3 = a^{11}/a^9 = a^2.$$

L'équation (3') se réduit à
$X + \sigma_1 = 0$
d'où $X = \sigma_1 = a^2$
ce qui vérifie l'hypothèse faite pour la position de l'erreur.

L'erreur corrigée est la quantité $y_1$ qui est calculé par l'équation (2). On trouve:

$$y_1 = S_0 = a^3$$

**Revendication**

1. Codeur-décodeur convertissant un message informationnel exprimé en code binaire en un message exprimé en code de Reed-Solomon et inversement, comprenant:
des moyens de sélection d'un polynôme générateur de code G (x) ayant comme racines les puissances successives d'un élément primitif appartenant au champ de Galois CG($2^3$);
des moyens de division dudit message informationnel par ledit polynôme générateur de code G (x), lesdits moyens de division permettant d'obtenir un mot de code

$$V(x) = \sum_{i=0}^{i=n-1} y_i x^i \text{ comprenant}$$

(n–8) symboles d'information et 8 symboles de code, formule dans laquelle y donne la valeur du symbole, x la position du symbole et n le degré du mot de code;
des moyens de réception desdits mots de code éventuellement entachés d'au plus quatre erreurs au cours de leur transmission;
des moyens de calculer des syndromes d'erreurs

$$V(a^j) = \sum_{i=0}^{i=n-1} y_i (a^j)^i = S_j$$

où j peut prendre les valeurs de 0 à 7 inclus, ces syndromes d'erreurs étant les valeurs prises par le mot de code reçu quand on y remplace la variable par les éléments ($a^j$) du champ de Galois C6 ($2^3$);
des moyens de calculer à partir desdits syndromes les coefficients $\delta_t$ où t est au plus égal à 4 d'un polynôme localisateur d'erreurs, lesdits coefficients dépendant desdits syndromes par un premier système d'équations linéaires;

$$S_4 + \delta_1 S_3 + \delta_2 S_2 + \delta_3 S_1 + \delta_4 S_0 = 0$$
$$S_7 + \delta_1 S_6 + \delta_2 S_5 + \delta_3 S_4 + \delta_4 S_3 = 0$$

des moyens de calculer les racines dudit polynôme localisateur d'erreurs, lesdites racines étant les positions des erreurs dans le mot de code;
ledit codeur-décodeur étant caractérisé en ce qu'il comprend en outre des moyens de former un second système d'équations linéaires ((18))

$$S_0 = Y_1 + A_2 + Y_3 + Y_4$$
$$S_3 = Y_1 X_1^3 + Y_2 X_2^3 + Y_3 X_3^3 + Y_4 X_4^3$$

reliant les valeurs y des erreurs aux syndromes S et aux positions x des erreurs délivrés respectivement par les moyens de calculer les syndromes d'erreurs et par les moyens de calculer les racines du polynôme localisateur d'erreurs, des moyens de résoudre ledit second système d'équations linéaires, les valeurs trouvées pour y étant des erreurs; et

en ce que les moyens de calculer les racines du polynôme localisateur d'erreurs comprennent:
des unités de calcul permettant de résoudre respectivement, en en calculant les racines, les équations du quatrième degré, du troisième degré et du second degré; et

des moyens d'appliquer ledit polynôme localisateur d'erreurs auxdites unités de calcul du quatrième, troisième, second degrés selon que ledit polynôme localisateur est lui-même du quatrième, du troisième ou du second degré.

## Claim

1. Encoder-decoder converting an information message expressed in binary code into a message expressed in Reed-Solomon code and reciprocally, comprising:

means for selecting a code generator polynomial G(x) having, as roots, the successive powers of a primitive element belonging to the Galois field CG($2^3$);

means for dividing said information message by said code generator polynomial G(x), saids dividing means being capable of producing a code word

$$V(x) = \sum_{i=0}^{i=n-1} y_i x^i$$

comprising (n–8) information symbols and 8 code symbols, formula in which y denotes the value of the symbol, x the location of the symbol and n the degree of the code word;

means for receiving said code words possibly erroneous with at the most four errors during their transmission;

means for calculating error syndromes

$$V(a^j) = \sum_{i=0}^{i=n-1} y_i (a^j)^i = S_j$$

where j can take the values from 0 to 7 exclusively, said error syndromes being the values taken by the received code word where the variable in this word is replaced by the elements ($a^j$) of the Galois field CG($2^3$);

means for calculating the coefficient $\delta_t$ of an error-locating polynomial from said syndromes where t is at the most equal to 4, said coefficients depending on said syndromes through a first linear equation system;

$$S_4 + \delta_1 S_3 + \delta_2 S_2 + \delta_3 S_1 + \delta_4 S_0 = 0$$
$$S_7 + \delta_1 S_6 + \delta_2 S_5 + \delta_3 S_4 + \delta_4 S_3 = 0$$

means for calculating the roots of said error-locating polynomial, said roots being the error locations in the code word;

said encoder-decoder being characterized in that it further comprises

means for forming a second linear equation system ((18))

$$S_0 = Y_1 + A_2 + Y_3 + Y_4$$
$$S_3 = Y_1 X_1^3 + Y_2 X_2^3 + Y_3 X_3^3 + Y_4 X_4^3$$

linking the error values y to the syndromes S and to the error locations x respectively supplied by the error syndrome calculating means and by the error locating polynomial root calculating means, means for solving said second linear equation system, the found values for y being the values of the errors; and

in that the error-locating polynomial root calculating means comprise:

calculation units for respectively solving the equations of fourth degree, third degree and second degree by calculating the roots thereof; and means for applying said error-locating polynomial into said fourth, third, second-degree calculation units depending on whether said locating polynomial is itself of the fourth, third or second degree.

## Patentanspruch

1. Umformer zum Überführen einer im Binärkode vorliegenden Information in einer Reed-Solomon-kodierte Information und umgekehrt, bestehend aus:

- einer Einrichtung zur Wahl eines Erzeugerpolynoms des Kodes G (x), das als Wurzeln die aufeinanderfolgenden Potenzen eines zum Galois-Feld CG ($2^3$) gehörenden einfachen Elementes hat;

- einer Einrichtung zum Teilen der Information durch dieses Erzeugerpolynom des Kodes G (x), die ein Kodewort

$$V(x) = \sum_{i=0}^{i=n-1} y_i x^i$$

zu erhalten erlaubt, das (n-8) Informationssymbole und 8 Kodiersymbole umfasst, wobei in der Formel y den Wert der Symbole, x die Position der Symbole und n den Grad des Kodewortes bezeichnen;

- einer Einrichtung zum Empfang dieser Kodeworte, die eventuell mit höchstens vier Fehlern während ihrer Übertragung behaftet sein können;

- einer Einrichtung zum Berechnen von Fehlersyndromen

$$V(a^j) = \sum_{i=0}^{i=n-1} y_i (a^j)^i = S_j$$

wobei j die Werte von 0 bis einschliesslich 7 einnehmen kann und diese Fehlersyndrome die durch das empfangene Kodewort belegten Werte sind, wenn man dort die Veränderliche durch die Elemente ($a^j$) des Galois-Feldes CG ($2^3$) ersetzt;

- einer Einrichtung zum Berechnen der Koeffizienten $\delta_t$ – wobei t höchstens gleich 4 ist – eines Polynomes zur Fehlerlokalisierung aus den Fehlersyndromen, wobei diese Koeffizienten von diesen Syndromen nach einem ersten System linearer Gleichungen abhängen:

$$S_4 + \delta_1 S_3 + \delta_2 S_2 + \delta_3 S_1 + \delta_4 S_0 = 0$$
$$S_7 + \delta_1 S_6 + \delta_2 S_5 + \delta_3 S_4 + \delta_4 S_3 = 0$$

- einer Einrichtung zum Berechnen der Wurzeln des Polynoms zur Fehlerlokalisierung, und diese Wurzeln die Positionen der Fehler im Kodewort bezeichnen;

gekennzeichnet durch folgende weitere Einrichtungen:

- eine Einrichtung zum Bilden eines zweiten Systemes linearer Gleichungen ((18))

$$S_0 = Y_1 + A_2 + Y_3 + Y_4$$
$$S_3 = Y_1 X_1^3 + Y_2 X_2^3 + Y_3 X_3^3 + Y_4 X_4^3$$

das die Werte y der Fehler mit den Syndromen S und den Positionen x der Fehler verbindet, die entsprechend durch die Einrichtung zum Berechnen der Fehlersyndrome und durch die Einrichtung zum Berechnen der Wurzeln des Polynoms zur Fehlerlokalisierung geliefert sind;

– eine Einrichtung zum Lösen des zweiten Systemes linearer Gleichungen, wobei die dabei gefundenen Werte die Fehlerwerte sind;

und dadurch gekennzeichnet, dass die Einrichtung zum Berechnen der Wurzeln des Polynoms zur Fehlerlokalisierung aufweist:

– Recheneinheiten, die beim Berechnen der Wurzeln ein Lösen der Gleichungen des vierten Grades, des dritten Grades und des zweiten Grades erlauben; und

– Mittel zum Anwenden des Polynoms zur Fehlerlokalisierung auf die Recheneinheiten für den vierten, dritten, zweiten Grad, je nachdem das Polynom zur Fehlerlokalisierung selbst vom vierten, dritten oder zweiten Grad ist.

FIG -1

MEMOIRE VIVE de mots U de p bits

**10**

Entrée / Sortie

**11**
Table

**12**
Unité de stockage de p bits

**16**

**13**
$\oplus$

Additionneur   modulo 2

**14**
Unité de stockage de p bits

**15**
Table

## FIG-2

# FIG-3